# FASCICULE DE BREVET EUROPEEN

(11) **EP 0 775 375 B1**
(45) Date de publication et mention de la délivrance du brevet: **18.11.1998**
(21) Numéro de dépôt: 95927012.5
(22) Date de dépôt: 02.08.1995
(51) Int. Cl.: H01R 23/00, H01R 23/02, H04M 1/02

(54) **PRISE RESEAU A FAIBLE DIAPHONIE**
ANSPEISENETZWERK MIT NIEDRIGEM ÜBERSPRECHEN
LOW CROSS-TALK NETWORK CONNECTOR

(30) Priorité: 08.08.1994 FR 9409812
(43) Date de publication de la demande: 28.05.1997
(73) Titulaire: FRAMATOME CONNECTORS INTERNATIONAL, 92400 Courbevoie, Paris (FR)
(72) Inventeur: GARCIN, Michel, F-25300 Pontarlier (FR)
(74) Mandataire: Keib, Gérard
(86) Numéro de dépôt international: FR9501042
(87) Numéro de publication internationale: WO9605635

(56) Documents cités:
- EP-A- 0 558 225
- EP-A- 0 598 192
- US-A- 4 790 769

## Description

La présente invention concerne un connecteur électrique comprenant plusieurs entrées et plusieurs sorties électriquement interconnectées au moyen de conducteurs électriques espacés les uns des autres et montés sur une surface électriquement isolante.

Le connecteur électrique visé par l'invention est destiné particulièrement aux prises réseau haut débit dans lesquelles les conducteurs véhiculent des signaux électriques de fréquence supérieure à 1 MHz.

Ces prises sont du type "Jack téléphone" ou RJ45. Des exemples de réalisation de telles prises sont décrits dans les FR-A-2 694 456 et US-A-5 186 647. Ces prises comprennent un corps de prise qui se monte sur un châssis ou un boîtier mural. Le corps de prise comporte une embase munie de contacts filaires destinée à effectuer la connexion avec une fiche complémentaire.

Pour les signaux de fréquence inférieure à 1 MHz, la compensation de la diaphonie est effectuée par transposition des conducteurs reliés à l'embase c'est-à-dire en les torsadant par paires. Par contre, lorsque la fréquence des signaux dépasse 1 MHz, la compensation de la diaphonie est insuffisante et il est nécessaire de compenser celle-ci au niveau des contacts dans les prises et donc de croiser les entrées et sorties par paires.

Dans le cas des prises de type RJ45, le schéma normalisé fait correspondre les points de contact des entrées et des sorties selon la configuration suivante:

1-A, 2-B, 3-F, 4-D, 5-E, 6-C, 7-G, 8-H, les chiffres 1, 2, 3, 4, 5, 6, 7, 8 correspondant aux sorties du connecteur et les lettres A, B, C, D, E, F, G, H aux entrées.

Dans le but de compenser la diaphonie, le brevet US-5 186 647 enseigne de croiser les conducteurs sous forme de fils non isolés dans une zone où ces fils sont parallèles.

Cette solution nécessite la réalisation de conducteurs munis de zones de croisement dans leur région de maintien dans l'isolant et requiert de munir cet isolant de cloisons de séparation multiples. Cette solution est difficilement réalisable pour des croisements de fils non contigus.

Le document US-A-4 790 769 décrit une prise réseau avec une embrase comportant plusieurs entrées et sorties situées dans deux plans, étant reliées l'une à l'autre à l'intersection des deux plans.

Le but de la présente invention est de remédier à cet inconvénient.

L'invention vise ainsi un connecteur électrique comprenant plusieurs entrées et plusieurs sorties électriquement interconnectées au moyen de conducteurs électriques espacés les uns des autres et montés sur une surface en matière électriquement isolante.

Suivant l'invention, ce connecteur est caractérisé en ce que les entrées sont situées dans un premier plan de ladite surface, et les sorties sont situées dans un second plan de ladite surface, chaque entrée étant reliée à la sortie correspondante par un conducteur qui comprend une première partie qui s'étend sur le premier plan et une seconde partie qui s'étend sur le second plan, les deux parties étant reliées l'une à l'autre à l'intersection des deux plans, et en ce que les entrées sont alignées suivant une disposition symétrique par rapport à l'intersection entre les deux plans.

L'invention réalise ainsi la transposition des conducteurs par un changement de plan simultané de tous les points de connexion, sans croisement des conducteurs. Grâce à ce changement de plan, on réduit considérablement le couplage magnétique entre les conducteurs, c'est-à-dire la diaphonie.

Ce principe permet une configuration de transposition des entrées/sorties quelconque sans augmentation de la longueur des conducteurs.

Selon une version préférée de l'invention, les deux plans de la surface isolante sont perpendiculaires.

De préférence également, les sorties sont alignées parallèlement à l'intersection des deux plans et les conducteurs situés dans le plan des sorties s'étendent parallèlement les uns par rapport aux autres.

Selon une première version, les entrées sont disposées suivant deux rangées.

Selon une deuxième version, les entrées sont alignées suivant une rangée unique.

Une autre caractéristique de la présente invention concerne l'embase de la prise réseau qui est moulée d'une seule pièce en matière plastique, les conducteurs pouvant être surmoulés dans l'embase ou insérés dans des évidements ménagés dans l'embase.

Selon une autre caractéristique de la présente invention, cette embase peut aussi comprendre un premier bloc sensiblement parallélépipédique surmonté par un second bloc s'étendant verticalement du premier bloc et au milieu de celui-ci, les entrées étant alignées sur la face du premier bloc opposée au second bloc, les sorties étant alignées sur le sommet du second bloc et étant prolongées par des lamelles conductrices repliées vers une face latérale du second bloc.

Dans ce cas, l'embase peut être en deux parties distinctes, l'une étant constituée par une plaquette sur laquelle est imprimée une partie des conducteurs reliés aux entrées et l'autre étant constituée par un bloc dans lequel est surmoulée ou insérée l'autre partie des conducteurs reliés aux sorties, ledit bloc étant fixé de façon amovible sur la plaquette de façon à établir une connexion entre les deux parties des conducteurs.

Les conducteurs reliés aux entrées peuvent se terminer sur la plaquette par des extrémités présentant des ouvertures alignées suivant une direction perpendiculaire aux entrées, les conducteurs reliés aux sorties se terminant à la base du bloc par des extrémités pénétrant dans les ouvertures précitées pour établir le contact électrique entre lesdites extrémités des conducteurs.

Les entrées peuvent être prolongées par des conducteurs se terminant en cul de sac pour réaliser une compensation en capacité.

Le boîtier peut comprendre sur les bords de sa face adjacente à l'embase des pattes en saillie munies de becs d'encliquetage venant en prise avec deux bords opposés du bloc comportant les entrées de l'embase pour fixer celui-ci de façon amovible au boîtier de réception.

Enfin, les entrées de l'embase (11,12) situées à l'opposé du boîtier de réception peuvent recevoir chacune une lame conductrice munie d'une fente, lesdites lames étant coiffées par un bloc isolant fixé de façon amovible à l'embase et comportant des encoches pour l'insertion de fils conducteurs d'entrée, les fentes pratiquées dans lesdites lames étant destinées à la connexion desdits fils.

Dans tous les cas, l'invention permet de réaliser l'interconnexion entre des sorties 1, 2, 3, 4, 5, 6, 7, 8 et des entrées A, B, C, D, E, F, G, H suivant la configuration: 1-A, 2-B, 3-F, 4-D, 5-E, 6-C, 7-G, 8-H.

D'autres particularités et avantages de l'invention apparaîtront encore dans la description ci-après.

Aux dessins annexés et donnés à titre d'exemples non limitatifs:
la figure 1 est un schéma montrant les interconnexions entre les entrées et sorties situées dans deux plans différents, selon une première version de l'invention;
la figure 2 est une projection dans le plan des entrées des interconnexions de la figure 1;
la figure 3 est un schéma analogue à la figure 1, relatif à une deuxième version de l'invention;
la figure 4 est une projection dans le plan des entrées des interconnexions de la figure 3;
la figure 5 est un schéma analogue à la figure 1, relatif à une troisième version de l'invention;
la figure 6 est une projection dans le plan des entrées des interconnexions de la figure 5;
la figure 7 est une vue en plan d'une embase d'un connecteur selon l'invention;
la figure 8 est une vue dans le plan des entrées des conducteurs d'interconnexion;
la figure 9 est une vue de côté de l'embase;
la figure 10 est une vue en perspective des conducteurs d'interconnexion;
la figure 11 est une vue en perspective de l'embase;
la figure 12 est une vue suivant un plan perpendiculaire à celui de la figure 8, des conducteurs d'interconnexion;
la figure 13 est une vue suivant un plan perpendiculaire à celui de la figure 7, de l'emabas;
la figure 14 est une vue en plan d'une embase comportant une plaquette à conducteurs imprimés;
la figure 15 est une vue en plan des conducteurs d'interconnexion;
la figure 16 est une vue de côté de l'embase;
la figure 17 est une vue en perspective des conducteurs d'interconnexion;
la figure 18 est une vue en perspective de l'embase;
la figure 19 est une vue en plan des conducteurs d'interconnexion;
la figure 20 est une vue en plan de l'embase suivant un plan perpendiculaire à celui de la figure 14;
la figure 21 est une vue éclatée d'une prise selon l'invention comprenant une embase monobloc et un boîtier de réception;
la figure 22 est une vue analogue à la figure 21 concernant une variante de réalisation;
la figure 23 est une autre vue en perspective éclatée, de la variante selon la figure 22;
la figure 24 est une vue en perspective éclatée d'un ensemble embase-boîtier de réception d'une deuxième variante de réalisation;
la figure 25 est une vue en perspective éclatée d'une troisième variante;
la figure 26 est une vue en perspective montrant l'embase de la figure 25 montée dans un boîtier de réception.

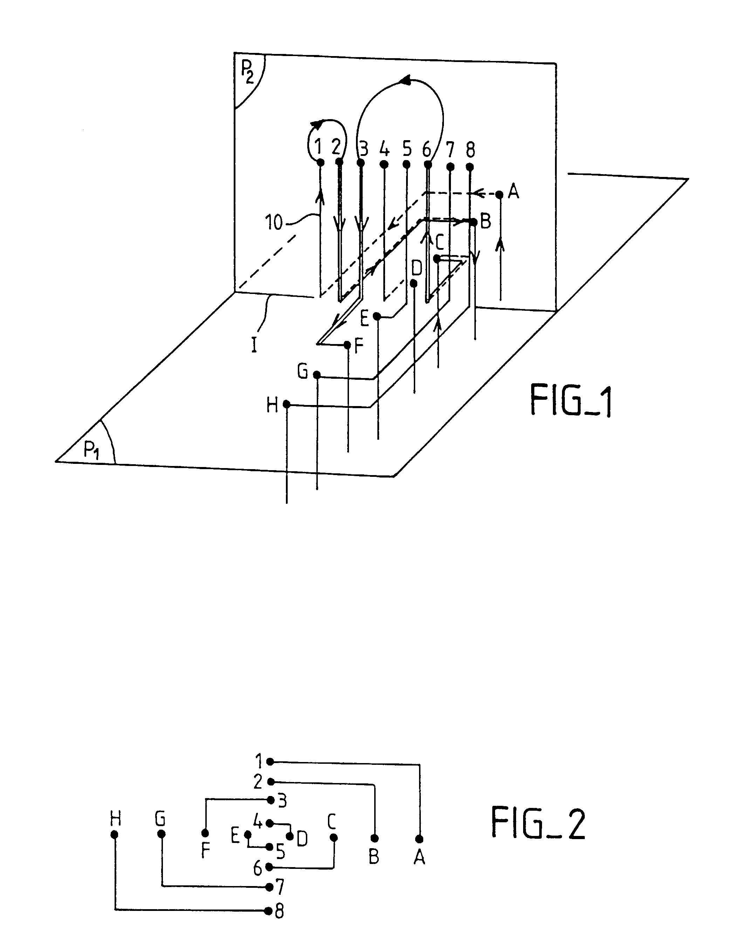

Sur la figure 1, on a représenté schématiquement des connecteurs électriques comprenant plusieurs entrées A, B, C, D, E, F, G, H et plusieurs sorties 1, 2, 3, 4, 5, 6, 7, 8 électriquement interconnectées au moyen de conducteurs électriques 10 espacés les uns des autres et montés sur une surface électriquement isolate P₁, P₂.

Conformément à l'invention, les entrées A,..., H sont situées dans un premier plan P₁ de la surface électriquement isolante et les sorties 1,..., 8 sont situées dans un second plan P₂ de cette surface. Chaque entrée A,..., H est reliée à la sortie 1,..., 8 correspondante par un conducteur qui comprend une première partie qui s'étend sur le premier plan P₁ et une seconde partie qui s'étend sur le second plan P₂, ces deux parties étant reliées l'une à l'autre sensiblement à angle droit à l'intersection des deux plans P₁, P₂, aucun croisement n'ayant lieu entre les conducteurs.

Dans les exemples représentés, les deux plans P₁, P₂ sont perpendiculaires.

Par ailleurs, les sorties 1, 2, 3, 4, 5, 6, 7, 8 sont alignées parallèlement à l'intersection I des deux plans P₁, P₂ et les conducteurs 10 situés dans le plan P₂ des sorties 1,..., 8 s'étendent parallèlement les uns par rapport aux autres.

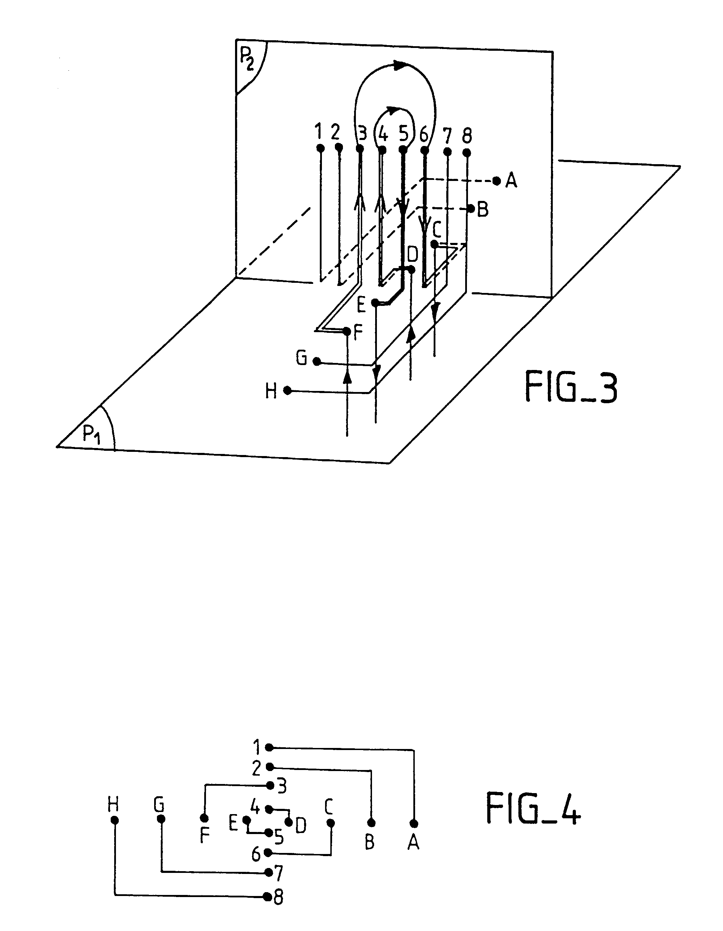

Dans le cas des figures 1 à 4, les entrées A,..., H sont alignées suivant une rangée unique qui est symétrique par rapport à l'intersection I entre les deux plans P₁, P₂.

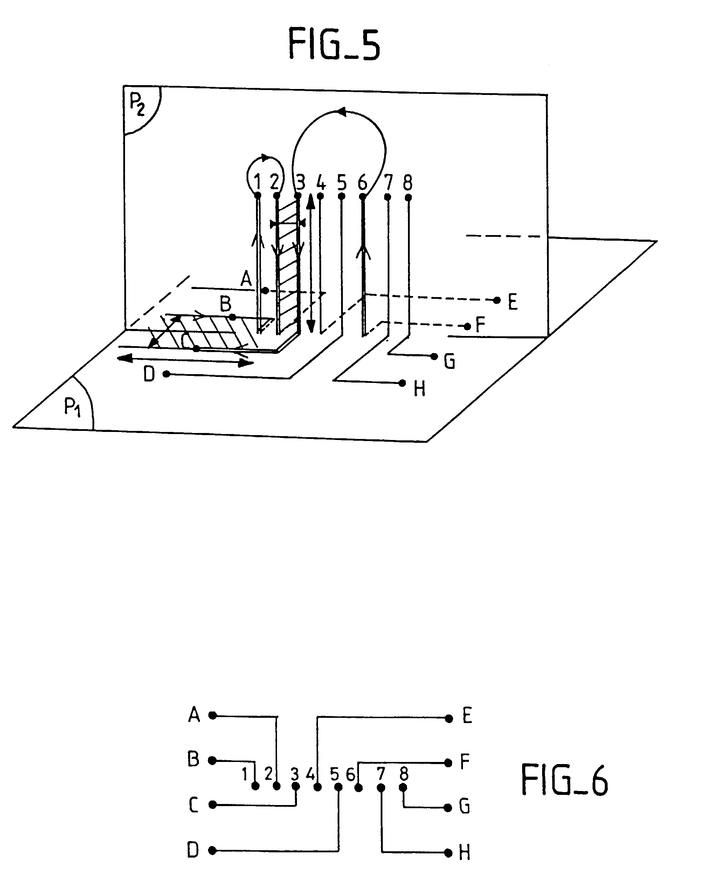

Dans le cas des figures 5 et 6, les entrées sont disposées suivant deux rangées A, B, C, D et E, F, G, H, parallèles et symétriques par rapport à l'intersection I entre les deux plans P₁, P₂.

Dans le cas des figures 1 à 4, les liaisons électriques entre les entrées et les sorties sont:
1-A; 2-B; 3-F; 4-D; 5-E: 6-C; 7-G; 8-H.

Dans le cas des figures 5 et 6, ces liaisons sont:
1-B; 2-A; 3-C; 4-E; 5-D; 6-F; 7H; 8-G.

On peut ainsi à partir de ces schémas, réaliser des prises réseau haute fréquence, par exemple du type "Jack téléphone" ou "RJ45" à très faible diaphonie.

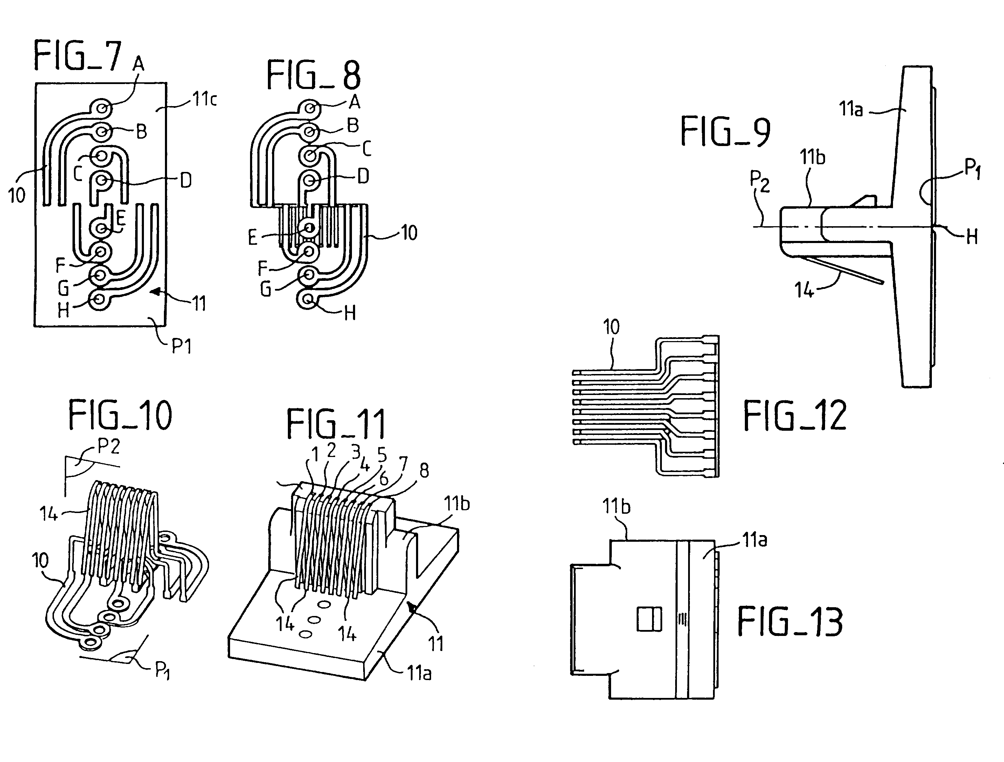

On va maintenant décrire en référence aux figures 7 à 20, quelques exemples de réalisations de connecteurs électriques mettant en oeuvre le principe précité.

Dans ces réalisations, les entrées A, B, C, D, E, F, F, H et les sorties 1, 2, 3, 4, 5, 6, 7, 8 sont électriquement interconnectées au moyen de conducteurs électriques 10 espacés les uns des autres et montés sur une embase 11, 12 en matière électriquement isolante.

L'embase 11, 12 comporte deux plans P1, P2 perpendiculaires, les entrées A,..., H étant situées dans un premier plan P₁ et les sorties 1, ..., 8 étant situées dans un second plan P₂. Chaque entrée A,..., H est reliée à la sortie 1,..., 8 correspondante par un conducteur 10 qui comprend une première partie qui s'étend sur le premier plan P₁ et une seconde partie qui s'étend sur le second plan P₂, les deux parties étant reliées l'une à l'autre sensiblement à angle droit à l'intersection I des deux plans P₁, P₂, aucun croisement n'ayant lieu entre les conducteurs.

Dans l'exemple représenté sur les figures 7 à 13, l'embase 11 est moulée d'une seule pièce en matière plastique.

Les conducteurs 10 peuvent être surmoulés dans l'embase 11. Ces conducteurs 10 peuvent également être insérés dans des évidements ménagés dans l'embase 11.

Comme on le voit sur les figures 9, 11 et 13, l'embase 11 comprend un premier bloc 11a sensiblement parallélépipédique surmonté par un second bloc 11b s'étendant verticalement du premier bloc 11 à partir du milieu de celui-ci.

Les entrées A,..., H sont alignées sur la face llc du premier bloc 11a opposée au second bloc 11b et les sorties 1,..., 8 sont alignées sur le sommet 13 du second bloc 11b. Par ailleurs, ces sorties 1,..., 8 sont prolongées par des lamelles conductrices 14 repliées vers une face latérale du second bloc 11b.

De plus, les entrées A,..., H sont alignées sur la face 11c de l'embase, suivant une direction perpendiculaire à l'alignement des sorties 1,..., 8.

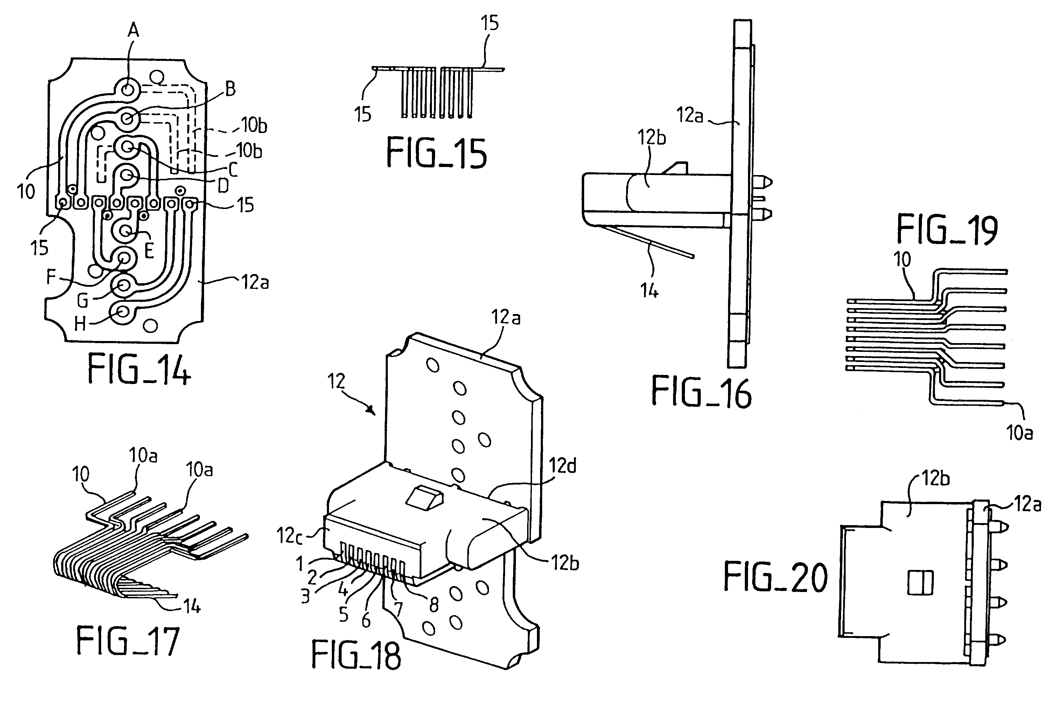

Dans la réalisation des figures 14 à 20, l'embase 12 est en deux parties distinctes 12a, 12b. La partie 12a est constituée par une plaquette isolante sur laquelle est imprimée une partie des conducteurs 10 reliés aux entrées A, B, C, D, E, F, G, H et l'autre partie 12b est constituée par un bloc 12b dans lequel est surmoulée ou insérée l'autre partie des conducteurs 10 reliés aux sorties 1, 2, 3, 4, 5, 6, 7, 8. Le bloc 12b est fixé de façon amovible sur la plaquette 12a de façon à établir une connexion entre les deux parties des conducteurs 10.

Les conducteurs reliés aux sorties 1,..., 8 font saillie du sommet 12c du bloc 12b et sont prolongés par des lamelles 14 repliées vers une face latérale de ce bloc.

Les conducteurs 10 reliés aux entrées A,..., H se terminent sur la plaquette 12a par des extrémités présentant des ouvertures 15 alignées suivant une direction perpendiculaire aux entrées A,..., H. Les conducteurs reliés aux sorties 1,..., 8 se terminent à la base 12e du bloc 12b par des extrémités 10a pénétrant dans les ouvertures 15 précitées pour établir le contact électrique entre les extrémités des conducteurs.

Le bloc 12b pourrait également être fixé à plat contre la plaquette 12b. Dans ce cas, le bloc présente sur l'un de ses côtés, des extrémités saillantes des conducteurs moulés et insérés dans le bloc, ces extrémités saillantes étant repliées perpendiculairement à la plaquette et engagées dans des ouvertures alignées ménagées aux extrémités des conducteurs portés par la plaquette.

Le bloc 12b présente également dans ce cas, sur son autre côté, des extrémités saillantes des conducteurs, ces extrémités saillantes étant cambrées et repliées vers la face du bloc opposée à la plaquette.

Les entrées A,... H pourraient également être situées suivant deux rangées parallèles.

Comme indiqué sur la figure 15, les entrées A, ..., H peuvent être prolongées par des conducteurs 10b se terminant en cul de sac pour réaliser une compensation en capacité.

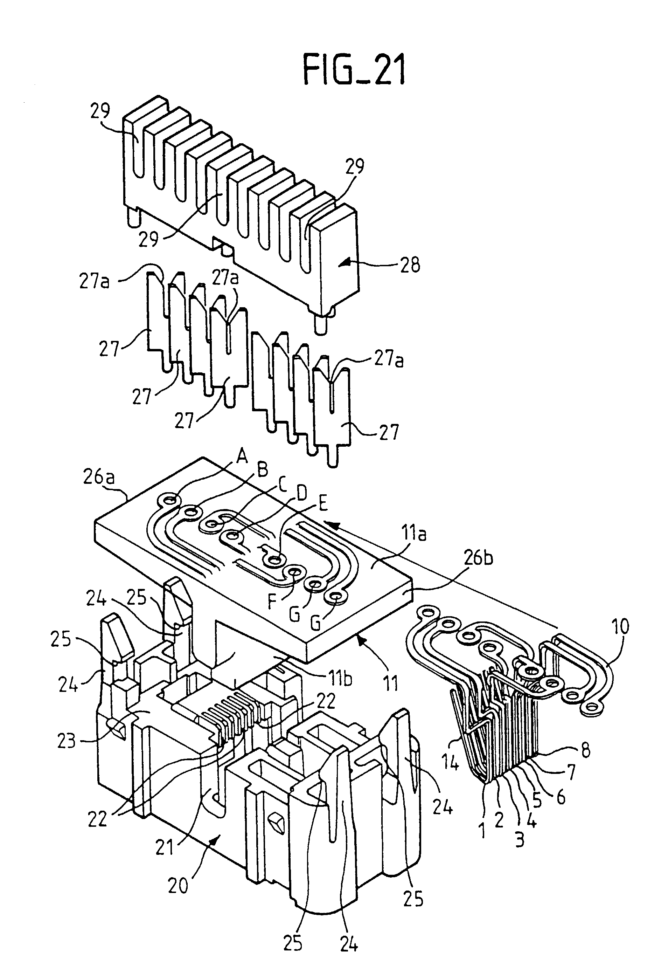

La figure 21 représente une prise réseau à faible diaphonie, comprenant une embase 11 en matière isolante comportant plusieurs entrées A,..., H et plusieurs sorties 1,... 8 électriquement interconnectées au moyen de conducteurs électriques 10 espacés les uns des autres. Cette embase 11 est monobloc et est identique à celle représentée sur la figure 11. Cette embase 11 est montée de façon amovible dans un boîtier de réception 20 comportant des moyens pour établir la connexion électrique entre les sorties 1,..., 8 de l'embase 11 et des fils conducteurs de sortie extérieurs (non représentés) . Les entrées A,..., H de l'embase 11 sont connectées avec des moyens pour établir la connexion électrique avec des fils conducteurs d'entrée extérieurs.

Comme déjà indiqué précédemment, l'embase 11 comporte deux plans sensiblement perpendiculaires, les entrées A,..., H étant situées dans un premier plan et les sorties 1,... 8 étant situées dans un second plan, chaque entrée étant reliée à la sortie correspondante par un conducteur qui comprend une première partie qui s'étend sur le premier plan et une seconde partie qui s'étend sur le second plan, les deux parties étant reliées l'une à l'autre à l'intersection des deux plans, aucun croisement n'ayant lieu entre les conducteurs.

L'embase 11 comprend un bloc 11a sensiblement parallélépipédique comprenant sur l'une de ses faces des entrées A,..., H alignées et sur sa face opposée un bloc 11b faisant saillie verticalement sur cette face duquel font saillie des lames conductrices 14 constituant les sorties alignées suivant une direction perpendiculaire aux entrées. Ces lames 14 étant repliées vers une face latérale du bloc 11b faisant saillie.

Le boîtier de réception 20 comprend un évidement 21 recevant le bloc 11b en saillie de l'embase 11.

Cet évidement 21 comporte sur sa face adjacente aux lames conductrices 14 repliées du bloc 11b de l'embase des encoches 22 destinées à recevoir chacune une lame 14 conductrice du bloc 11b. Ces lames 14 viennent en contact avec des fils conducteurs de sortie extérieurs (non représentés).

On voit également sur la figure 21, que le boîtier 20 comprend sur les bords de sa face 23 adjacente à l'embase 11 des pattes 24 en saillie munies de becs d'encliquetage 25 venant en prise avec deux bords opposés 26a, 26b du bloc 11a comportant les entrées A,..., H de l'embase 11 pour fixer celui-ci de façon amovible sur la face 23 du boîtier de réception 20.

Par ailleurs, les entrées A,... H de l'embase 11 situées à l'opposé du boîtier de raccordement 20 reçoivent chacune une lame conductrice 27 munie d'une fente 27a. Ces lames 27 sont coiffées par un bloc isolant 28 fixé de façon amovible à l'embase 11. Le bloc 28 comporte des encoches 29 pour l'insertion de fils conducteurs d'entrée; les fentes 27a pratiquées dans les lames 27 sont destinées à la connexion desdits fils par déplacement de leur isolant extérieur.

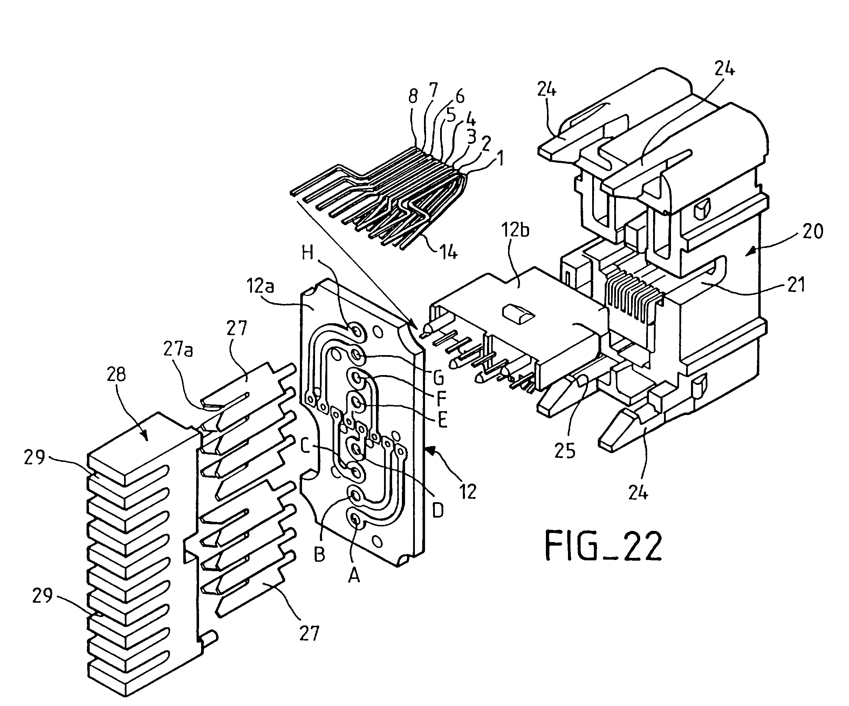

La figure 22 est identique à la figure 21, sauf que l'embase 12 est en deux parties 12a, 12b comme représenté sur la figure 18.

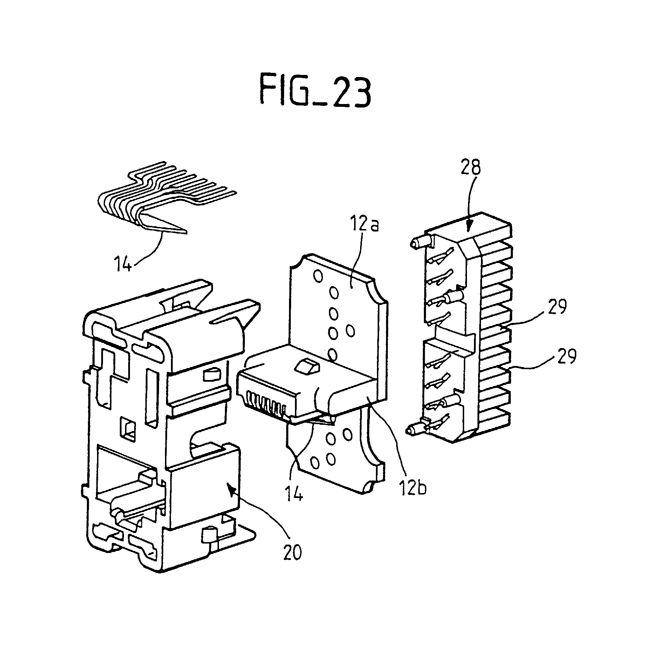

La figure 23 montre le même ensemble que la figure 22, sous une autre direction de vue.

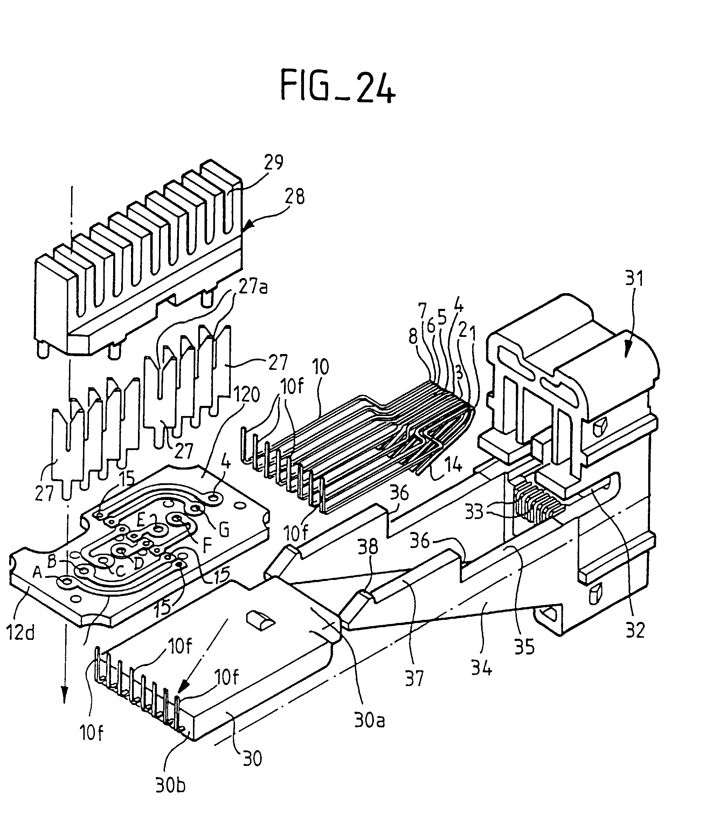

Dans la réalisation de la figure 24, l'embase 12 comprend une plaquette 12a présentant sur l'une de ses faces les entrées A,..., H. Cette plaquette 12a est identique à celle représentée sur la figure 14. La plaquette 12a est appliquée contre un bloc 30 sensiblement parallélépipédique duquel font saillie sur l'un des côtés, des extrémités 10f de conducteurs 14 repliés à angle droit vers la plaquette 12a. Les extrémités 10f de ces conducteurs sont engagées dans des ouvertures 15 pratiquées dans la plaquette 12a par lesquels elles sont connectées aux conducteurs 10 reliés aux entrées A,..., H.

Le côté opposé du bloc 30 sensiblement parallélépipédique présente des extrémités de conducteurs 14 en saillie repliées vers la face du bloc opposée à la plaquette 12a.

Le boîtier de réception 31 comporte un évidement 32 pour recevoir le côté 30a dudit bloc duquel font saillie les extrémités 14 repliées des conducteurs 10. Cet évidement 32 comporte sur sa face adjacente aux extrémités 14 repliées des conducteurs, des encoches 33 destinées à recevoir chacune l'une desdites extrémités 14 pour établir la connexion électrique avec les fils conducteurs de sortie. Le boîtier de réception 31 comporte en outre sur sa face adjacente à l'évidement 32 une protubérance 34 comportant une face évidée 35 présentant un épaulement 36 à l'opposé de l'évidement 32 du boîtier. Le bloc sensiblement parallélépipédique 30 lorsqu'il est engagé par son côté 30a dans l'évidement 32, son côté opposé 30b est en appui contre l'épaulement 36.

On voit également sur la figure 24 que la protubérance 34 est prolongée au-delà de l'épaulement 36 par une surface d'appui 37 de la plaquette 12a appliquée sur le bloc 30. A cet effet, l'extrémitéde la protubérance 34 comporte un épaulement 38 pour caler le bord 12d de la plaquette 12a.

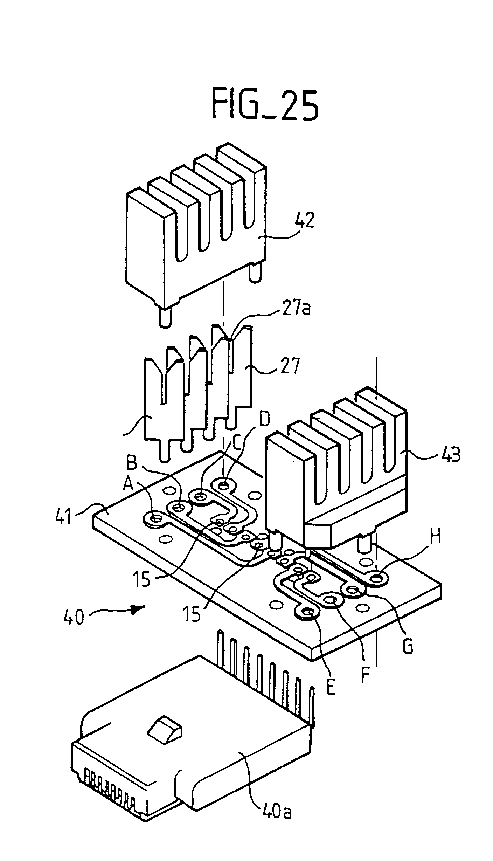

La figure 25 représente une embase 40 en deux parties, l'une étant constituée par une plaquette 41 sur laquelle les conducteurs sont imprimés, les entrées A,..., H étant disposées suivant deux rangées parallèles. Le bloc 40a comportant les conducteurs reliés aux sorties 1,..., 8 est identique au bloc représenté sur la figure 18.

Les lames de contacts 27 destinés à être reliées aux fils conducteurs extérieurs sont coiffées par deux blocs isolants 42, 43 disposés au-dessus des deux rangées d'entrées, A, B, C, D, et E, F, G, H.

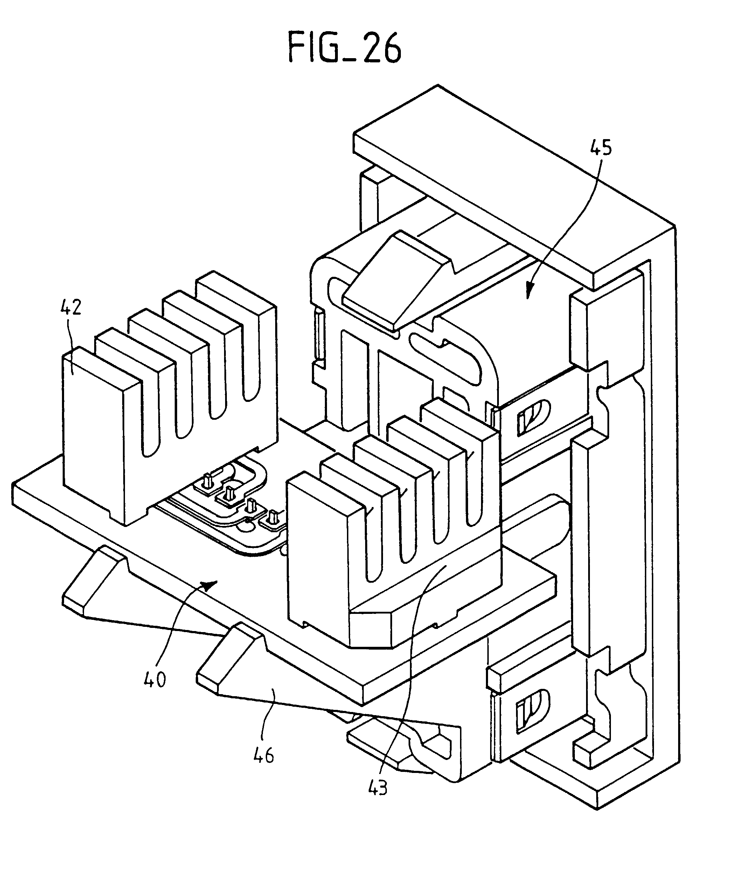

La figure 26 représente un boîtier de réception recevant l'embase 40 ci-dessus. Comme dans la réalisation de la figure 24, le boîtier 45 comprend des protubérances latérales 46 servant au calage de l'embase 40.

## Revendications

1. Prise réseau à faible diaphonie, comprenant une embase (11, 12, 30, 40) en matière isolante comportant plusieurs entrées (A,... H) et plusieurs sorties (1,... 8) électriquement interconnectées au moyen de conducteurs électriques espacés les uns des autres, cette embase étant montée de façon amovible dans un boîtier de réception (20, 31, 45) comportant des moyens pour établir la connexion électrique entre les sorties de l'embase et des fils conducteurs de sortie extérieurs, les entrées (A,..., H) de l'embase étant connectées avec des moyens pour établir la connexion électrique avec des fils conducteurs d'entrée extérieurs, ladite embase (11, 12, ...) comportant deux plans sensiblement perpendiculaires, les entrées (A,... H) étant situées dans un premier plan et les sorties (1,... 8) étant situées dans un second plan, chaque entrée étant reliée à la sortie correspondante par un conducteur qui comprend une première partie qui s'étend sur le premier plan et une seconde partie qui s'étend sur le second plan, les deux parties étant reliées l'une à l'autre à l'intersection des deux plans caractérisée en ce que les entrées sont alignées suivant une disposition symétrique par rapport à l'intersection (I) entre les deux plans (P₁, P₂).

2. Prise réseau conforme à la revendication 1, caractérisée en ce que les sorties (1,... 8) sont alignées parallèlement à l'intersection (I) des deux plans (P₁,P₂) et en ce que les conducteurs (10) situés dans le plan (P₂) des sorties (1,... 8) s'étendent parallèlement les uns par rapport aux autres.

3. Prise réseau conforme à l'une des revendications 1 ou 2, caractérisée en ce que les entrées (A, ... H) sont disposées suivant deux rangées parallèles et symétriques par rapport à l'intersection (I) entre les deux plans.

4. Prise réseau conforme à l'une des revendications 1 ou 2, caractérisée en ce que les entrées (A, ... H) sont alignées suivant une rangée unique symétrique par rapport à l'intersection (I) entre les deux plans (P₁, P₂).

5. Prise réseau conforme à l'une des revendications 1 à 4, caractérisée en ce que l'embase (11) est moulée d'une seule pièce en matière plastique.

6. Prise réseau conforme à la revendication 5, caractérisée en ce que les conducteurs sont surmoulés dans l'embase (11).

7. Prise réseau conforme à la revendication 5, caractérisée en ce que les conducteurs sont insérés dans des évidements ménagés dans l'embase (11).

8. Prise réseau conforme à l'une des revendications 1 à 4, caractérisée en ce que l'embase (11) comprend un premier bloc (11a) sensiblement parallélépipédique surmonté par un second bloc (11b) s'étendant verticalement du premier bloc et au milieu de celui-ci, les entrées (A, ... H) étant alignées sur la face du premier bloc (11a) opposée au second bloc (11b), les sorties (1,... 8) étant alignées sur le sommet du second bloc et étant prolongées par des lamelles conductrices (14) repliées vers une face latérale du second bloc.

9. Prise réseau conforme à la revendication 8, caractérisée en ce que l'embase (12) est en deux parties distinctes, l'une (12a) étant constituée par une plaquette sur laquelle est imprimée une partie des conducteurs (10) reliés aux entrées (A, ... H) et l'autre (12b) étant consituée par un bloc dans lequel est surmoulée ou insérée l'autre partie des conducteurs (10) reliés aux sorties (1, ... 8), ledit bloc (12b) étant fixé de façon amovible sur la plaquette (12a) de façon à établir une connexion entre les deux parties des conducteurs (10).

10. Prise réseau conforme à la revendication 9, caractérisée en ce que les conducteurs (10) reliés aux entrées se terminent sur la plaquette (12a) par des extrémités présentant des ouvertures (15) alignées suivant une direction perpendiculaire aux entrées (A, ... H), les conducteurs reliés aux sorties (1, ... 8) se terminant à la base du bloc par des extrémités (10a) pénétrant dans les ouvertures (15) précitées pour établir le contact électrique entre lesdites extrémités des conducteurs (10).

11. Prise réseau conforme à l'une des revendications 1 à 10, caractérisée en ce que les entrées (A, ... H) sont prolongées par des conducteurs (10b) se terminant en cul de sac pour réaliser une compensation en capacité.

12. Prise conforme à l'une quelconque des renvendications précédentes, caractérisée en ce que le boîtier (20) comprend sur les bords de sa face (23) adjacente à l'embase (11,12) des pattes (24) en saillie munies de becs d'encliquetage (25) venant en prise avec deux bords opposés (26a,26b) du bloc comportant les entrées (A, ... H) de l'embase pour fixer celui-ci de façon amovible au boîtier de réception (20).

13. Prise conforme à l'une quelconque des renvendications précédentes, caractérisée en ce que les entrées (A, ... H) de l'embase (11,12) situées à l'opposé du boîtier de réception (20) reçoivent chacune une lame conductrice (27) munie d'une fente (27a), lesdites lames (27) étant coiffées par un bloc isolant (28) fixé de façon amovible à l'embase et comportant des encoches (29) pour l'insertion de fils conducteurs d'entrée, les fentes pratiquées dans lesdites lames étant destinées à la connexion desdits fils.

## Patentansprüche

1. Netzwerkstecker mit niedrigem Übersprechen, der einen Untersatz (11, 12, 30, 40) aus isolierendem Material mit mehreren Eingängen (A, ..., H) und mehreren Ausgängen (1, ..., 8) aufweist, die durch elektrisch leitende Einrichtungen elektrisch zusammengeschaltet und zueinander beabstandet sind, wobei dieser Untersatz in lösbarer Weise in einem Aufnahmegehäuse (20, 31, 45) montiert ist, das Einrichtungen umfaßt, die die elektrische Verbindung zwischen den Ausgängen des Untersatzes und Leitungsdrähten des äußeren Ausgangs herstellen, wobei die Eingänge (A, ..., H) des Untersatzes mit den Einrichtungen verbunden sind, die die elektrische Verbindung mit den Leitungsdrähten des äußeren Einganges herstellen, wobei dieser Untersatz (11, 12, ...) zwei im wesentlichen senkrechte Ebenen aufweist, wobei die Eingänge (A, ..., H) in einer ersten Ebene und die Ausgänge (1, ..., 8) in einer zweiten Ebene angeordnet sind und jeder Eingang mit dem entsprechenden Ausgang durch einen Leiter verbunden ist, der einen ersten Bereich, der sich auf der ersten Ebene erstreckt, und einen zweiten Bereich aufweist, der sich auf der zweiten Ebene erstreckt, wobei die zwei Bereiche an der Schnittgeraden der beiden Ebenen miteinander verbunden sind, ist dadurch gekennzeichnet, daß die Eingänge entsprechend einer Anordnung ausgerichtet sind, die bezüglich der Schnittgeraden (I) der beiden Ebenen (P₁, P₂) symmetrisch ist.

2. Netzwerkstecker nach Anspruch 1, dadurch gekennzeichnet, daß die Ausgänge (1, ..., 8) parallel zur Schnittgeraden (I) der beiden Ebenen (P₁, P₂) ausgerichtet sind und daß die Leiter (10), die in der Ebene (P₂) der Ausgänge (1, ..., 8) verlegt sind, zueinander parallel verlaufen.

3. Netzwerkstecker nach einem der Ansprüche 1 oder 2, dadurch gekennzeichnet, daß die Eingänge (A, ..., H) parallel zu zwei parallelen und zur Schnittgeraden (I) der beiden Ebenen symmetrischen Reihen angeordnet sind.

4. Netzwerkstecker nach einem der Ansprüche 1 oder 2, dadurch gekennzeichnet, daß die Eingänge (A, ..., H) nach einer einzigen Reihe, die bezüglich der Schnittgeraden (I) der beiden Ebenen (P₁, P₂) symmetrisch ist, ausgerichtet sind.

5. Netzwerkstecker nach einem der Ansprüche 1 bis 4, dadurch gekennzeichnet, daß der Untersatz (11) aus einem einzigen Plastikteil gegossen wird.

6. Netzwerkstecker nach Anspruch 5, dadurch gekennzeichnet, daß die Leiter in dem Untersatz (11) eingegossen sind.

7. Netzwerkstecker nach Anspruch 5, dadurch gekennzeichnet, daß die Leiter in den Aussparungen eingeführt sind, die in dem Untersatz (11) angebracht sind.

8. Netzwerkstecker nach einem der Ansprüche 1 bis 4, dadurch gekennzeichnet, daß der Untersatz (11) einen ersten im wesentlichen parallelepipedrischen Block (11a) aufweist, der durch einen zweiten Block (11b) überragt wird, der sich vertikal und in der Mitte des ersten Blocks ausdehnt, wobei die Eingänge (A, ..., H) auf der Oberfläche des ersten Blocks (11a) entgegengesetzt zum zweiten Block (11b) ausgerichtet sind, wobei die Ausgänge (1, ..., 8) auf der Spitze des zweiten Blocks verlaufen und durch leitende Blattfedern (14) verlängert werden, die in Richtung einer Seitenfläche des zweiten Blocks umgebogen sind.

9. Netzwerkstecker nach Anspruch 8, dadurch gekennzeichnet, daß der Untersatz (12) aus zwei verschiedenen Teilen aufgebaut ist, wobei das eine (12a) aus einem Plättchen gebildet wird, auf dem ein Teil der Leiter (10) aufgedruckt ist, die mit den Eingängen (A, ..., H) verbunden sind, und das andere (12b) durch einen Block gebildet wird, in dem der andere Bereich der Leiter (10) eingeschmolzen oder eingelassen ist, die mit den Ausgängen (1, ..., 8) verbunden sind, wobei dieser Block (12b) in lösbarer Weise auf dem Plättchen (12a) befestigt ist, damit eine Verbindung zwischen den zwei Bereichen der Leiter (10) hergestellt wird.

10. Netzwerkstecker nach Anspruch 9, dadurch gekennzeichnet, daß die Leiter (10), die an den Eingängen angeschlossen sind, auf dem Plättchen (12a) mit Enden aufhören, die Öffnungen (15) aufweisen und senkrecht zu den Eingängen (A, ..., H) ausgerichtet sind, daß die Leiter, die an den Ausgängen (1, ..., 8) angeschlossen sind, in der Blockbasis als Enden (10a) aufhören, die durch die vorher genannten Öffnungen (15) durchgehen, um den elektrischen Kontakt zwischen diesen Leiterenden (10) herzustellen.

11. Netzwerkstecker nach einem der Ansprüche 1 bis 10, dadurch gekennzeichnet, daß die Eingänge (A, ..., H) durch Leiter (10b) verlängert werden, die in einer Sackgasse enden, um einen kapazitiven Abgleich zu erfüllen.

12. Netzwerkstecker nach irgendeinem der vorhergehenden Ansprüche, dadurch gekennzeichnet, daß das Gehäuse (20) auf dem Rand der Oberfläche (23), die mit der des Untersatzes (11, 12) anstößt, überstehende Haken aufweist, die mit Einrastnasen (25) versehen sind, die in Verbindung mit den zwei gegenüberliegenden Rändern (26a, 26b) des Blockes gebracht werden, die die Eingänge (A, ..., H) des Untersatzes umfassen, um diesen in lösbarer Weise an dem Aufnahmegehäuse (20) zu befestigen.

13. Netzwerkstecker nach irgendeinem der vorhergehenden Ansprüche, dadurch gekennzeichnet, daß die Eingänge (A, ..., H) des Untersatzes (11, 12), die auf der gegenüberliegenden Seite des Aufnahmegehäuses (20) verlegt sind, jeweils eine leitende Zunge (27) erhalten, die mit einem Spalt (27a) versehen ist, wobei diese Zungen (27) durch einen Isolierblock (28) abgedeckt werden, der lösbar an dem Untersatz befestigt ist, und Vertiefungen (29) für das Einziehen von Eingangsleiterdrähten aufweist, wobei die Spalte, die in diesen Zungen eingearbeitet sind, für die Verbindung dieser Drähte vorgesehen sind.

## Claims

1. Low-crosstalk network connector, comprising a base (11, 12, 30, 40) made of insulating material having several inputs (A,... H) and several outputs (1, ... 8) which are electrically interconnected by means of mutually spaced electrical conductors, this base being mounted in a removable manner in a receiving box (20, 31, 45) having means for establishing the electrical connection between the outputs of the base and exterior output conductor wires, the inputs (A, ..., H) of the base being connected with means for establishing the electrical connection with exterior input conductor wires, the said base (11, 12, ...) including two substantially perpendicular planes, the inputs (A,... H) being located in a first plane and the outputs (1,... 8) being located in a second plane, each input being linked to a corresponding output by a conductor which comprises a first part which extends over the first plane and a second part which extends over the second plane, the two parts being linked together at the intersection of the two planes, characterized in that the inputs are aligned in a symmetric arrangement with respect to the intersection (I) between the two planes (P₁, P₂).

2. Network connector according to Claim 1, characterized in that the outputs (1,... 8) are aligned parallel to the intersection (I) of the two planes (P₁, P₂) and in that the conductors (10) located in the plane (P₂) of the outputs (1,... 8) extend parallel with respect to one another.

3. Network connector according to one of Claims 1 or 2, characterized in that the inputs (A, ... H) are arranged in two parallel rows which are symmetric with respect to the intersection (I) between the two planes.

4. Network connector according to one of Claims 1 or 2, characterized in that the inputs (A, ... H) are aligned in a single row which is symmetric with respect to the intersection (I) between the two planes (P₁, P₂).

5. Network connector according to one of Claims 1 to 4, characterized in that the base (11) is moulded in one piece of plastic.

6. Network connector according to Claim 5, characterized in that the conductors are overmoulded in the base (11).

7. Network connector according to Claim 5, characterized in that the conductors are inserted into recesses made in the base (11).

8. Network connector according to one of Claims 1 to 4, characterized in that the base (11) comprises a first substantially parallelepipedal block (11a) surmounted by a second block (11b) extending vertically from the first block and in the middle of the latter, the inputs (A, ... H) being aligned on that face of the first block (lla) which is opposite the second block (11b), the outputs (1,... 8) being aligned on the top of the second block and being extended by conductive strips (14) bent over towards a lateral face of the second block.

9. Network connector according to Claim 8, characterized in that the base (12) is in two distinct parts, one (12a) consisting of a board on which is printed a part of the conductors (10) linked to the inputs (A, ... H) and the other (12b) consisting of a block in which the other part of the conductors (10) linked to the outputs (1, ... 8) is overmoulded or inserted, the said block (12b) being fixed in a removable manner to the board (12a) so as to establish a connection between the two parts of the conductors (10).

10. Network connector according to Claim 9, characterized in that the conductors (10) linked to the inputs terminate on the board (12a) via ends having openings (15) aligned along a direction perpendicular to the inputs (A, ... H), the conductors linked to the outputs (1, ... 8) terminating at the bottom of the block via ends (10a) penetrating the aforementioned openings (15) in order to establish electrical contact between the said ends of the conductors (10).

11. Network connector according to one of Claims 1 to 10, characterized in that the inputs (A, ... H) are extended by conductors (10b) which terminate in a cul-de-sac in order to effect capacitance compensation.

12. Connector according to any one of the preceding claims, characterized in that on the edges of its face (23) which is adjacent to the base (11, 12), the box (20) comprises projecting lugs (24) having snap-fastening tabs (25) which engage with two opposed edges (26a, 26b) of the block containing the inputs (A, ... H) of the base in order to fix the latter in a removable manner to the receiving box (20).

13. Connector according to any one of the preceding claims, characterized in that the inputs (A, ... H) of the base (11, 12) which are located opposite the receiving box (20) each receive a conductive blade (27) having a slot (27a), the said blades (27) being covered by an insulating block (28) fixed in a removable manner to the base and containing notches (29) for inserting conductive input wires, the slots made in the said blades being intended for the connection of the said wires.
